# EUROPEAN PATENT APPLICATION

(11) **EP 4 300 550 A1**
(43) Date of publication of application: **03.01.2024**
(21) Application number: 21934371.2
(22) Date of filing: 10.08.2021
(51) Int. Cl.: H01L 21/336, H01L 29/78, H01L 29/423

(54) **SEMICONDUCTOR DEVICE HAVING SPLIT GATE STRUCTURE AND MANUFACTURING METHOD THEREFOR**

(30) Priority: 30.03.2021 CN 202110340660
(71) Applicant: CSMC Technologies Fab2 Co., Ltd., Wuxi New District Wuxi Jiangsu 214028 (CN)
(72) Inventor: FANG, Dong, Wuxi, Jiangsu 214028 (CN); XIAO, Kui, Wuxi, Jiangsu 214028 (CN)
(74) Representative: Canzler & Bergmeier Patentanwälte Partnerschaft mbB
(86) International application number: PCT/CN2021/111816
(87) International publication number: WO 2022/205727

(57) **Abstract**

The present invention relates to a semiconductor device having a split gate structure and a manufacturing method therefor. The method comprises: obtaining a substrate provided with a trench; forming a trench wall oxide isolation dielectric on an inner surface; filling the trench with a split gate material to form a split gate; forming a first oxide isolation dielectric on the split gate; forming a silicon nitride isolation dielectric on the first oxide isolation dielectric; filling, with a second oxide isolation dielectric, the position above the split gate in the trench where the silicon nitride isolation dielectric is not formed; and forming a control gate on the second oxide isolation dielectric. In the present invention, the isolation structure between the split gate and the control gate is a multi-dielectric structure comprising the first oxide isolation dielectric, the silicon nitride isolation dielectric, and the second oxide isolation dielectric. Compared with the solution of using a single oxide layer dielectric, the gate-source withstand voltage is higher.

## Description

### TECHNICAL FIELD

The present disclosure relates to the field of semiconductor manufacturing, in particular to a semiconductor device having a split gate structure and a method for manufacturing the same.

### BACKGROUND

Trench vertical double-diffused metal oxide semiconductor (VDMOS) products are widely used power devices. Since the introduction of split-gate device structures, there has been a trend of replacing medium and low voltage ordinary trench VDMOS products with trench split-gate VDMOS devices due to the advantages of low resistance and low gate capacitance of split-gate structures. For split-gate structures, the oxide layer (isolation oxide layer) for isolating the control gate and the split gate is critical to the electrical properties of the device.

### SUMMARY

It is necessary to provide a semiconductor device having a new type of split gate isolation structure with a high gate-source voltage resistance, and a manufacturing method therefor.

The present disclosure provides a method for manufacturing a semiconductor device having a split gate structure, which includes the following steps: obtaining a base formed with a trench; forming a trench wall oxide isolation dielectric on the inner surface of the trench, and forming a split gate by filling the trench with a split gate material; forming a first oxide isolation dielectric on the split gate; forming a silicon nitride isolation dielectric on the first oxide isolation dielectric; filling a second oxide isolation dielectric above the split gate in the trench in the position where the silicon nitride isolation dielectric is not formed; and forming a control gate on the second oxidation isolation dielectric.

With the above method for manufacturing the semiconductor device with the split gate structure, the thicknesses of the oxide dielectric layers will not affect each other during manufacturing, which is conducive to accurately controlling the thicknesss of the oxide dielectric layers. In addition, the isolation structure between the split gate and the control gate is a multi-dielectric structure including a first oxide isolation dielectric, a silicon nitride isolation dielectric, and a second oxide isolation dielectric, which has a higher gate-source voltage resistance compared to those using a single layer of oxide dielectric.

In an embodiment, the step of forming a split gate includes etching the split gate material to a desired split gate height. The step of forming a trench wall oxide isolation dielectric on the inner surface of the trench includes growing the trench wall oxide isolation dielectric by thermal oxidation. After the step of etching the split gate material and before the step of forming a first oxide isolation dielectric on the split gate, the method further includes a step of wet etching the trench wall oxide isolation dielectric to remove the trench wall oxide isolation dielectric on the sidewalls of the trench above the split gate. After the step of wet etching the trench wall oxide isolation dielectric and before the step of forming a silicon nitride isolation dielectric on the first oxide isolation dielectric, the method further includes the step of growing an oxide layer by thermal oxidation. The step of filling a second oxide isolation dielectric above the split gate in the trench in the position where the silicon nitride isolation dielectric is not formed includes: depositing the second oxide isolation dielectric; and wet etching the deposited second oxide isolation dielectric to obtain a second oxide isolation dielectric with a desired thickness.

In an embodiment, after the step of wet etching the deposited second oxide isolation dielectric to obtain a second oxide isolation dielectric with a desired thickness and before forming a control gate on the second oxidation isolation dielectric, the method further includes: wet etching the silicon nitride isolation dielectric and the oxide layer grown by thermal oxidation; and forming a gate oxide layer on the sidewalls of the trench above the silicon nitride isolation dielectric by thermal oxidation.

In an embodiment, after the step of forming a control gate on the second oxidation isolation dielectric, the method further includes the step of forming a well region and a source region. The well region has a second conductivity type, and the source region has a first conductivity type. The well region is formed on two sides of the control gate, and the source region is formed outside the trench. The source region includes a first region and a second region. The first region is formed on the surface of the well region, the second region is located close to the side walls of the trench, and the depth of the first region is less than that of the second region. The first conductivity type and the second conductivity type are opposite conductivity types.

In an embodiment, the step of forming a source region including introducing ions of the first conductive type by tilt implantation.

In an embodiment, the semiconductor device is a vertical double-diffused metal oxide semiconductor field effect transistor, and the method for manufacturing the device further includes a step of forming a drain region on the back side of the base.

In an embodiment, after the step of forming a well region and a source region, the method further includes: forming the interlayer dielectric by deposition on the control gate and on the base; forming contact holes and filling the contact holes with a conductive material. The contact holes extend downward through the interlayer dielectric into the source region.

In an embodiment, after the step of forming the contact holes and before the step of filling the contact holes with the conductive material, the method further includes a step of forming a doped region of a second conductivity type within the well region and under the source region.

The present disclosure also provides a semiconductor device having a split gate structure. The semiconductor device includes: a base, having a first surface formed with a trench; a trench wall oxide isolation dielectric, disposed on the inner surface of the trench; a split gate, disposed at the bottom of the trench where the trench is not filled with the trench wall oxide isolation dielectric; a control gate, located in the upper part of the trench; and an isolation structure, located between the split gate and the control gate, including a first oxide isolation dielectric disposed on the split gate, a second oxide isolation dielectric disposed near the control gate, and a silicon nitride isolation dielectric disposed between the first oxide isolation dielectric and the second oxide isolation dielectric.

In an embodiment, the silicon nitride isolation dielectric is disposed at the bottom and sides of the second oxide isolation dielectric.

In an embodiment, the semiconductor device further includes: a well region, formed outside the trench and on two sides of the control gate; and a source region, having a first conductivity type, and formed outside the trench. The source region includes a first region and a second region. The first region is formed on the surface of the well region, the second region is located close to the side walls of the trench, and the depth of the first region is less than that of the second region. The first conductivity type and the second conductivity type are opposite conductivity types.

In an embodiment, the top of the control gate is lower than the top of the trench, thus forming a height difference between the source region and the control gate.

In an embodiment, the semiconductor device further includes: an interlayer dielectric, disposed on the base and the control gate; and a source electrode, disposed on the interlayer dielectric, and electrically connected to the source region through a conductive material filled in the contact holes. The contact holes extend downward through the interlayer dielectric into the source region.

In an embodiment, the semiconductor device further includes a doped region of a second conductivity type. The doped region of a second conductivity type is disposed within the well region and under the source region. The contact holes extend downward through the source region into the doped region of a second conductivity type.

In an embodiment, the semiconductor device is a vertical double-diffused metal oxide semiconductor field effect transistor. The semiconductor device further includes a drain disposed on a second surface of the base, the second surface being an opposite surface of the first surface.

In an embodiment, the base includes a substrate and an epitaxial layer, and the first surface of the base refers to the surface of the epitaxial layer.

In an embodiment, the first conductivity type is of type N, and the second conductivity type is of type P.

In the above semiconductor device having a split gate structure, the isolation structure between the split gate and the control gate is a multi-dielectric structure including a first oxide isolation dielectric, a silicon nitride isolation dielectric, and a second oxide isolation dielectric, which has a higher gate-source voltage resistance compared to those using a single layer of oxide dielectric.

### BRIEF DESCRIPTION OF THE DRAWINGS

To better describe and illustrate the embodiments and/or examples of the present disclosure, one or more figures may be referred to. Additional details or examples used to describe the figures should not be considered as limiting the scope of the present disclosure, the embodiments and/or examples described herein, or the best mode of the present disclosure as currently understood.
FIG. 1 is a schematic cross-sectional view of a semiconductor device having a split gate structure according to an embodiment of the present disclosure.
FIG. 2 is a flow chart showing a method for manufacturing a semiconductor device having a split gate structure according to an embodiment of the present disclosure.
FIGs. 3a to 3i are schematic cross-sectional views of various stages in the manufacturing process of a semiconductor device having a split gate structure according to an embodiment of the present disclosure.

### DETAILED DESCRIPTION

To facilitate understanding of the invention, a more comprehensive description of the present disclosure will be given below with reference to the relevant figures. The figures show the preferred embodiment of the present disclosure. However, the present disclosure can be implemented in many different forms and is not limited to the embodiments described herein. Instead, the purpose of providing these embodiments is to make the disclosure of the invention more thorough and comprehensive.

Unless otherwise defined, all technical and scientific terms used herein have the same meaning as commonly understood by those skilled in the art to which the present disclosure belongs. The terms used in this specification are for the purpose of describing specific embodiments only and are not intended to limit the present disclosure. The term "and/or" used herein includes any and all combinations of one or more of the associated listed items.

It should be understood that when an element or layer is referred to as being "on," "adjacent to," "connected to," or "coupled to" another element or layer, it may be directly on, adjacent to, connected or coupled to the other element or layer, or there may be intervening elements or layers present. In contrast, when an element is referred to as being "directly on," "directly adjacent to," "directly connected to," or "directly coupled to" another element or layer, there are no intervening elements or layers present. It should be understood that although terms such as first, second, third, etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present disclosure.

The oxide layer (isolating oxide layer) that isolates the control gate from the split gate is crucial to the electrical properties of a semiconductor device. If the oxide layer is too thin, it is prone to cause gate oxide breakdown. If the oxide layer is too thick, the drift region cannot be fully depleted, resulting in large leakage current in the device. Exemplary implementations of the isolating oxide layer includes: (a) thin thermal oxide layer + chemical vapor deposition (CVD); and (b) thermal oxide layer. With (a), an isolating oxide layer with a relatively large thickness within a controllable range can be achieved, but the process complexity is high; (b) has a low process complexity, but the thickness of the isolating oxide layer is correlated with the thickness of the gate oxide layer.

The present disclosure provides a trench semiconductor device having a split gate structure by means of multi-dielectric isolation, and a method for manufacturing the semiconductor device. The semiconductor device having a split gate structure includes:
a base, having a first surface formed with a trench;
a trench wall oxide isolation dielectric, disposed on an inner surface of the trench;
a split gate, disposed at the bottom of the trench where the trench is not filled with the trench wall oxide isolation dielectric;
a control gate, located in the upper part of the trench; and
an isolation structure, located between the split gate and the control gate, including a first oxide isolation dielectric disposed on the split gate, a second oxide isolation dielectric disposed near the control gate, and a silicon nitride isolation dielectric disposed between the first oxide isolation dielectric and the second oxide isolation dielectric.

In the above semiconductor device having a split gate structure, the isolation structure between the split gate and the control gate is a multi-dielectric structure including a first oxide isolation dielectric, a silicon nitride isolation dielectric, and a second oxide isolation dielectric, which has a higher gate-source voltage resistance compared to those having a single layer of oxide dielectric.

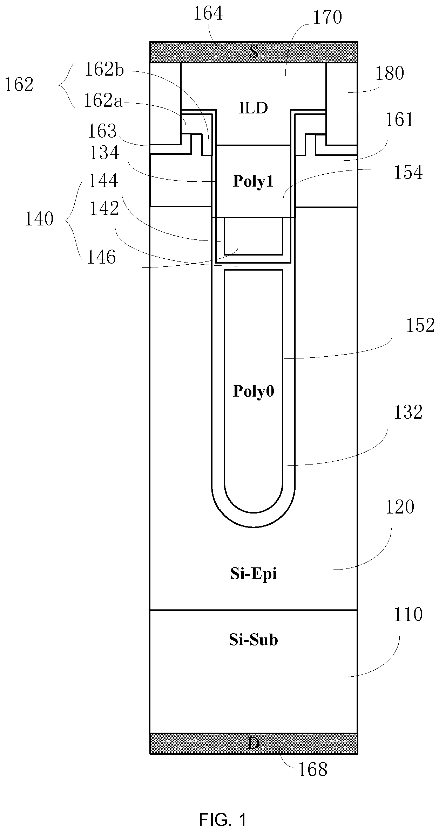

FIG. 1 is a schematic sectional view of a semiconductor device having a split gate structure according to an embodiment of the present disclosure. In this embodiment, the base includes a substrate 110 and an epitaxial layer 120, and a trench is opened downward from the surface of the epitaxial layer 120. The isolation structure 140 between the split gate 152 and the control gate 154 includes a first oxide isolation dielectric 142, a silicon nitride isolation dielectric 144, and a second oxide isolation dielectric 146. In FIG. 1, the silicon nitride isolation dielectric 144 is a U-shaped structure that envelops the bottom and sides of the second oxide isolation dielectric 146. The first oxide isolation dielectric 142 is also a U-shaped structure. A part of the first oxide isolation dielectric 142 is formed on the silicon nitride isolation dielectric 144, and another part of the first oxide isolation dielectric 142 is formed on the side walls of the trench, such that the first oxide isolation dielectric 142 envelops the bottom and sides of the silicon nitride isolation dielectric 144.

In the embodiment shown in FIG. 1, the semiconductor device having a split gate structure further includes a well region 161 and a source region 162. The well region 161 has a second conductivity type, and is formed outside the trench and on both sides of the control gate 154. The source region 162 has a first conductivity type, and is formed outside the trench. The source region 162 includes a first region 162a and a second region 162b. The first region 162a is formed on the surface of the well region 161, the second region 162b is located close to the side wall of the trench, and the depth of the first region 162a is less than that of the second region 162b. In the embodiment shown in FIG. 1, the first conductivity type is of type N, and the second conductivity type is of type P. In other embodiments, it may also be that the first conductivity type is of type P and the second conductivity type is of type N.

In the embodiment shown in FIG. 1, the top of the control gate 154 is lower than the top of the trench, thus forming a height difference between the source region 162 and the control gate 154. Since the top of the control gate 154 is lower than the top of the trench, the control gate 154 is located slightly below the source region 162, which can reduce the overlapping area between the source region 162 and the control gate 154, thereby reducing the gate-source capacitance.

In the embodiment shown in FIG. 1, the semiconductor device having a split gate structure further includes an interlayer dielectric (ILD) 170, a source electrode 164, and a contact hole 180. The interlayer dielectric (ILD) 170 is disposed on the epitaxial layer 120 and the control gate 154. The source electrode 164 is disposed on the interlayer dielectric 170. The source electrode 164 is electrically connected to the source region 162 through a conductive material filled in the contact hole 180. The contact hole 180 extends downward through the interlayer dielectric 170 into the source region 162.

In the embodiment shown in FIG. 1, the semiconductor device having a split gate structure further includes a doped region 163 of a second conductivity type. The doped region 163 of a second conductivity type is disposed within the well region 161 and under the source region 162. The contact hole 180 extends downward through the source region 162 into the doped region 163 of a second conductivity type.

In the embodiment shown in FIG. 1, the device is a trench vertical double-diffused metal oxide semiconductor field effect transistor (VDMOSFET) having a split gate. The device further includes a drain 168 disposed on the back side of the base.

In an embodiment of the present disclosure, the material of the silicon nitride isolation dielectric 144 is silicon nitride; the material of the trench wall oxide isolation dielectric 132 is silicon dioxide; the material of the first oxide isolation dielectric 142 is silicon dioxide; the material of the second oxide isolation dielectric 144 is silicon dioxide; the material of the split gate 152 is polycrystalline silicon; the material of the control gate 154 is polycrystalline silicon; the substrate 110 is a silicon substrate, and the epitaxial layer 120 is a silicon epitaxial layer.

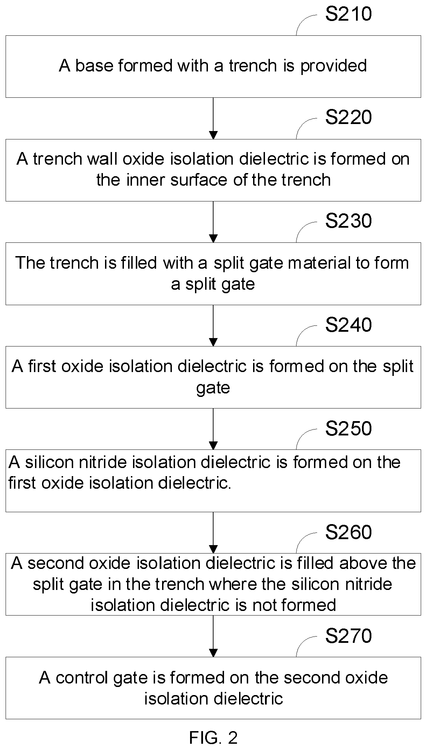

FIG. 2 is a flow chart showing a method for manufacturing the semiconductor device having a split gate structure according to an embodiment of the present disclosure, the method including the following steps:
S210, a base formed with a trench is provided.

After a silicon epitaxial layer 120 is epitaxially grown on the silicon substrate 110, the trench can be etched on the surface of the epitaxial layer 120.

S220, a trench wall oxide isolation dielectric is formed on the inner surface of the trench.

In an embodiment of the present disclosure, a thermal oxide layer is formed on the surface of the epitaxial layer and on the inner surface of the trench by thermal oxidation, and the thermal oxide layer is partially retained in subsequent steps as a trench wall oxide isolation dielectric 132.

S230, the trench is filled with a split gate material to form a split gate.

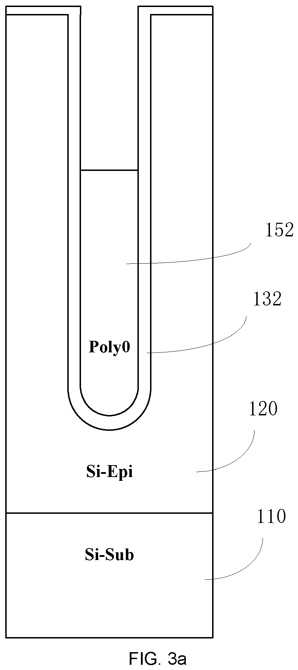

In an embodiment of the present disclosure, the split gate 152 with a desired thickness can be retained in the lower part of the trench by etching after the polycrystalline silicon is deposited, as shown in FIG. 3a. Further, the etching may be done by dry etching.

S240, a first oxide isolation dielectric is formed on the split gate.

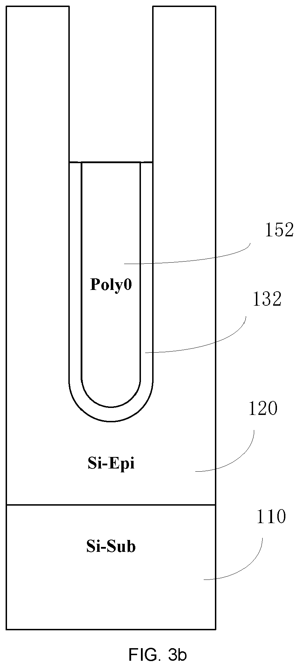

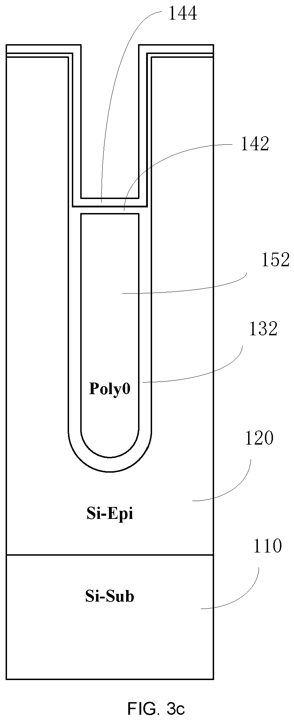

In one embodiment of the present disclosure, a thin oxide layer is formed on the upper surface of the split gate 152 by thermal oxidation as the first oxide isolation dielectric 142. In an embodiment of the present disclosure, before the step S240 is performed, wet etching is performed to remove the trench wall oxide isolation dielectric 132 on the sidewalls of the trench above the split gate 152 (as well as on the surface of the epitaxial layer 120), as shown in FIG. 3b. In step S240, the first oxide isolation dielectric 142 formed by thermal oxidation is also formed on the sidewalls of the trench and on the surface of the epitaxial layer 120, as shown in FIG. 3c.

S250, a silicon nitride isolation dielectric is formed on the first oxide isolation dielectric.

In an embodiment of the present disclosure, a silicon nitride layer is formed on the first oxide isolation dielectric 142 by a deposition process as a silicon nitride isolation dielectric 144.

S260, a second oxide isolation dielectric is filled above the split gate in the trench where the silicon nitride isolation dielectric is not formed.

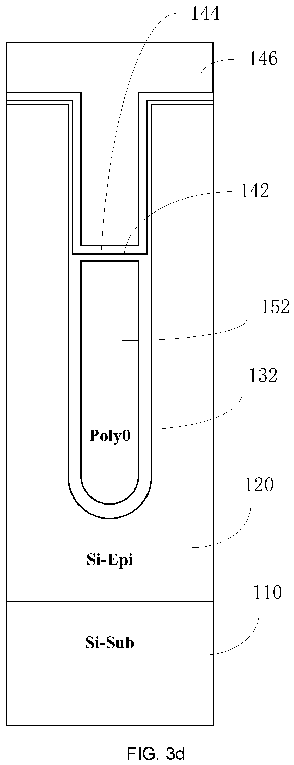

In an embodiment of the present disclosure, the trench may be filled with a silicon dioxide layer as a second oxide isolation dielectric 146 by a deposition process, as shown in FIG. 3d.

S270, a control gate is formed on the second oxide isolation dielectric.

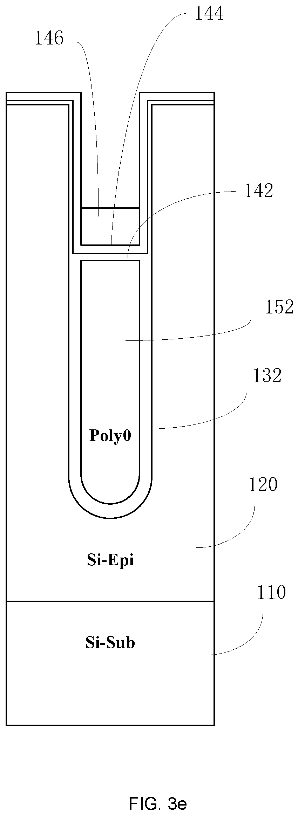

In an embodiment of the present disclosure, before the step S270 is performed, the method further includes a step of wet etching the deposited second oxide isolation dielectric to obtain a second oxide isolation dielectric 146 with a desired thickness, as shown in FIG. 3e. The desired thickness of the split gate 152 can be obtained by dry etching of the polycrystalline silicon, and the desired thickness of the second oxide isolation dielectric 146 can be obtained by wet etching. Therefore, the thickness of the isolation structure between the split gate 152 and the control gate 154 can be controlled precisely.

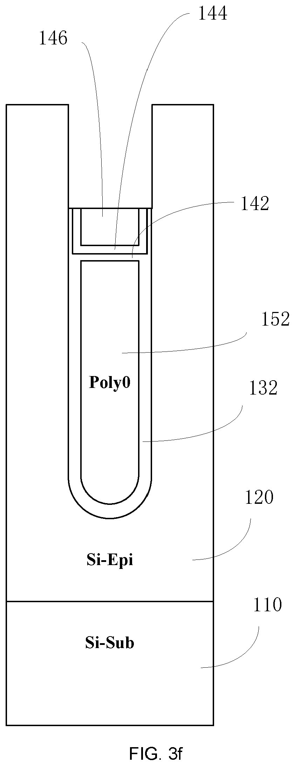

In an embodiment of the present disclosure, after the step of wet etching the deposited second oxide isolation dielectric 146 and before step S270, the method further includes a step of wet etching the silicon nitride isolation dielectric 144 and the first oxide isolation dielectric 142 (i.e., the first oxide isolation dielectric 142 on the sidewalls of the trench above the split gate 152 and on the surface of the epitaxial layer 120). Specifically, the silicon nitride isolation dielectric 144 and the first oxide isolation dielectric 142 are etched to the same height as the second oxide isolation dielectric 146, as shown in FIG. 3f.

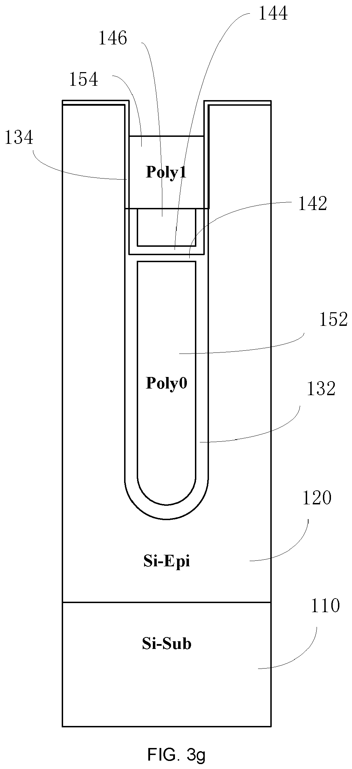

In an embodiment of the present disclosure, after the step of wet etching the silicon nitride isolation dielectric 144 and the first oxide isolation dielectric 142, the method further includes a step of forming a gate oxide layer 134 on the sidewalls of the trench above the silicon nitride isolation dielectric 144 by thermal oxidation, as shown in FIG. 3g.

In an embodiment of the present disclosure, before the step of wet etching the deposited second oxide isolation dielectric 146, the method further includes a step of grinding the second oxide isolation dielectric 146, and the grinding may be done by chemical mechanical grinding (CMP) with the silicon nitride isolation dielectric 144 being the grinding stop layer. The second oxide isolation dielectric 146 on the surface of the epitaxial layer 120 can be removed by grinding (i.e., the second oxide isolation dielectric 146 above the trench is removed).

In S270, the forming of the control gate 154 may be done by first depositing polycrystalline silicon and then etching the polycrystalline silicon.

In an embodiment of the present disclosure, after step S270, the method further includes a step of forming a well region 161 and a source region 162. The well region 161 has a second conductivity type, and the source region 162 has a first conductivity type. In an embodiment of the present disclosure, the first conductivity type is of type N, and the second conductivity type is of type P. In other embodiments, it may also be that the first conductivity type is of type P and the second conductivity type is of type N. The well region 161 is formed on both sides of the control gate 154, and the source region 162 is formed outside the trench. Both the well region 161 and the source region 162 may be formed by an ion implantation process.

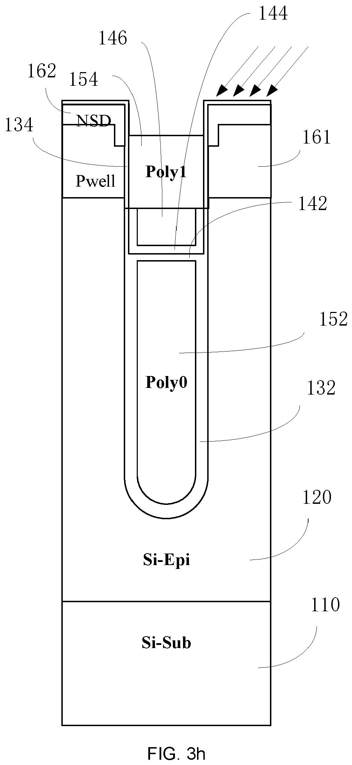

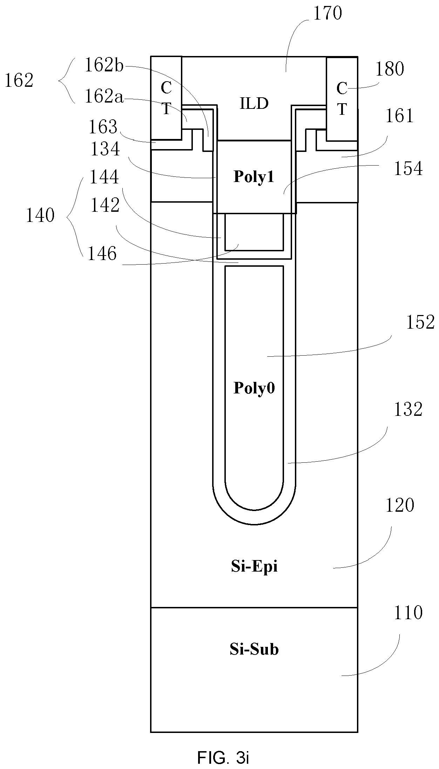

In an embodiment of the present disclosure, the implantation for forming the source region 162 is performed with an angle, i.e., tilt implantation, as shown by the arrow in FIG. 3h. Referring together to FIG. 3i, the source region 162 includes a first region 162a and a second region 162b. The first region 162a is formed on the surface of the well region 161, the second region 162b is located close to the side wall of the trench, and the depth of the first region 162a along a direction of the axis of the trench is less than that of the second region 162b. Tilt implantation can reduce the overlapping area of the source region 162 with the polycrystalline silicon of the control gate 154, thereby reducing the gate-source capacitance.

In an embodiment of the present disclosure, after forming the well region 161 and the source region 162, the method further includes a step of forming the interlayer dielectric 170 by deposition on the control gate 154 and on the epitaxial layer 120. Contact holes 180 are formed after depositing the interlayer dielectric 170. Specifically, by lithography and etching, contact holes 180 extending downward through the interlayer dielectric 170 into the source region 162 can be formed. Then, the contact holes 180 are filled with a conductive material, such as a metal or alloy. In an embodiment of the present disclosure, after forming the contact holes 180 and before filling the contact holes 180 with the conductive material, a step of forming a doped region 163 of a second conductivity type within the well region 161 and under the source region 162 is also included. Specifically, the doped region 163 of a second conductivity type can be formed by implanting ions of the second conductivity type.

In an embodiment of the present disclosure, after filling the contact holes 180 with the conductive material, the method further includes a step of forming a source electrode 164 on the interlayer dielectric 170, and a step of forming a drain 168 on the back side of the substrate 110. The structure of the final semiconductor device can be seen in FIG. 1. The source electrode 164 is electrically connected to the source region 162 and the doped region 163 of a second conductivity type through the conductive material in the contact holes 180.

It should be understood that although the steps in the flowchart of FIG. 2 are displayed in sequence according to the direction of the arrows, these steps are not necessarily executed in the order indicated by the arrows. Unless explicitly stated, there is no strict order restriction on the execution of these steps, and these steps can be executed in any other orders. Moreover, at least some of the steps in FIG. 2 may include multiple steps or stages. These steps or stages do not necessarily have to be completed at the same time but can be executed at different times. The execution order of these steps or stages does not necessarily have to be sequential but can be executed alternately or in turn with other steps or at least part of the steps or stages in other steps.

The above embodiments only express several embodiments of the present disclosure. Their description is relatively specific and detailed, but it should not be understood as a limitation on the protection scope of the present disclosure. It should be noted that for those skilled in the art, variations and improvements may be made without departing from the spirit of the present disclosure, these variations and improvements are within the protection scope of the present disclosure. Therefore, the protection scope of the present disclosure shall be subject to the scope defined in claims.

## Claims

1. A method for manufacturing a semiconductor device having a split gate structure, comprising:
obtaining a base formed with a trench;
forming a trench wall oxide isolation dielectric on an inner surface of the trench, and forming a split gate by filling the trench with a split gate material;
forming a first oxide isolation dielectric on the split gate;
forming a silicon nitride isolation dielectric on the first oxide isolation dielectric;
filling a second oxide isolation dielectric above the split gate in the trench in a position where the silicon nitride isolation dielectric is not formed; and
forming a control gate on the second oxidation isolation dielectric.

2. The method for manufacturing the semiconductor device having the split gate structure according to claim 1, wherein the forming of the split gate comprises etching the split gate material to a desired split gate height;
wherein the forming of the trench wall oxide isolation dielectric on the inner surface of the trench comprises growing the trench wall oxide isolation dielectric by thermal oxidation; wherein after etching the split gate material and before forming the first oxide isolation dielectric on the split gate, the method further includes wet etching the trench wall oxide isolation dielectric to remove the trench wall oxide isolation dielectric on sidewalls of the trench above the split gate;
wherein after wet etching the trench wall oxide isolation dielectric and before forming the silicon nitride isolation dielectric on the first oxide isolation dielectric, the method further comprises growing an oxide layer by thermal oxidation;
wherein the filling of the second oxide isolation dielectric above the split gate in the trench in the position where the silicon nitride isolation dielectric is not formed comprises: depositing the second oxide isolation dielectric; and wet etching the deposited second oxide isolation dielectric to obtain the second oxide isolation dielectric with a desired thickness.

3. The method for manufacturing the semiconductor device having the split gate structure according to claim 2, wherein after wet etching the deposited second oxide isolation dielectric to obtain the second oxide isolation dielectric with the desired thickness and before forming the control gate on the second oxidation isolation dielectric, the method further comprises:
wet etching the silicon nitride isolation dielectric and the oxide layer grown by thermal oxidation; and
forming a gate oxide layer on sidewalls of the trench above the silicon nitride isolation dielectric by thermal oxidation.

4. The method for manufacturing the semiconductor device having the split gate structure according to claim 1, wherein after forming the control gate on the second oxidation isolation dielectric, the method further comprises forming a well region and a source region; wherein the well region has a second conductivity type, and the source region has a first conductivity type; the well region is formed on two sides of the control gate, and the source region is formed outside the trench; the source region includes a first region and a second region, wherein the first region of the source region is formed on a surface of the well region, the second region of the source region is located close to sidewalls of the trench, and a depth of the first region of the source region is less than that of the second region of the source region; wherein the first conductivity type and the second conductivity type are opposite conductivity types.

5. The method for manufacturing the semiconductor device having the split gate structure according to claim 4, wherein the forming of the source region comprises introducing ions of the first conductive type by tilt implantation.

6. The method for manufacturing the semiconductor device having the split gate structure according to claim 4, wherein after forming the well region and the source region, the method further comprises:
forming an interlayer dielectric by deposition on the control gate and on the base; and
forming contact holes, and filling the contact holes with a conductive material, wherein the contact holes extend downward through the interlayer dielectric into the source region.

7. The method for manufacturing the semiconductor device having the split gate structure according to claim 6, wherein after forming the contact holes and before filling the contact holes with the conductive material, the method further comprises forming a doped region of a second conductivity type within the well region and under the source region.

8. The method for manufacturing the semiconductor device having the split gate structure according to claim 1, wherein the semiconductor device is a vertical double-diffused metal oxide semiconductor field effect transistor, and the method further comprises forming a drain region on a back side of the base.

9. A semiconductor device having a split gate structure, comprising:
a base, having a first surface formed with a trench;
a trench wall oxide isolation dielectric, disposed on an inner surface of the trench;
a split gate, disposed at a bottom of the trench where the trench is not filled with the trench wall oxide isolation dielectric;
a control gate, located in the upper part of the trench; and
an isolation structure, located between the split gate and the control gate, including a first oxide isolation dielectric disposed on the split gate, a second oxide isolation dielectric disposed near the control gate, and a silicon nitride isolation dielectric disposed between the first oxide isolation dielectric and the second oxide isolation dielectric.

10. The semiconductor device having the split gate structure according to claim 9, wherein the silicon nitride isolation dielectric is disposed at a bottom and sides of the second oxide isolation dielectric.

11. The semiconductor device having the split gate structure according to claim 9, further comprising:
a well region, formed outside the trench and on two sides of the control gate; and
a source region, having a first conductivity type, and formed outside the trench, wherein the source region comprises a first region and a second region; wherein the first region of the source region is formed on a surface of the well region, the second region of the source region is located close to sidewalls of the trench, and the depth of the first region of the source region is less than that of the second region of the source region; wherein the first conductivity type and the second conductivity type are opposite conductivity types.

12. The semiconductor device having the split gate structure according to claim 11, wherein a top of the control gate is lower than a top of the trench, to form a height difference between the source region and the control gate.

13. The semiconductor device having the split gate structure according to claim 11, further comprising:
an interlayer dielectric, disposed on the base and the control gate; and
a source electrode, disposed on the interlayer dielectric, and electrically connected to the source region through a conductive material filled in contact holes, wherein the contact holes extend downward through the interlayer dielectric into the source region.

14. The semiconductor device having the split gate structure according to claim 13, further comprising:
a doped region of a second conductivity type, wherein the doped region of the second conductivity type is disposed within the well region and under the source region; wherein the contact holes extend downward through the source region into the doped region of the second conductivity type.

15. The semiconductor device having the split gate structure according to claim 9, wherein the semiconductor device is a vertical double-diffused metal oxide semiconductor field effect transistor, and wherein the semiconductor device further comprises a drain disposed on a second surface of the base, the second surface of the base being opposite to the first surface of the base.
